# EUROPÄISCHE PATENTSCHRIFT

(11) **EP 4 290 564 B1**
(45) Veröffentlichungstag und Bekanntmachung des Hinweises auf die Patenterteilung: **11.12.2024**
(21) Anmeldenummer: 22177526.5
(22) Anmeldetag: 07.06.2022
(51) Int. Cl.: H01L 21/687, C23C 16/458, H01L 21/673, H01L 21/67

(54) **GREIFER ZUM TRANSPORTIEREN EINER STEHEND ANGEORDNETEN HALBLEITERSCHEIBE UND VERFAHREN ZUM REINIGEN DER HALBLEITERSCHEIBE**
GRIPPER FOR TRANSPORTING AN UPRIGHT SEMICONDUCTOR WAFER AND METHOD FOR CLEANING THE SEMICONDUCTOR WAFER
PRÉHENSEUR PERMETTANT DE TRANSPORTER UNE TRANCHE DE SEMI-CONDUCTEUR DISPOSÉE VERTICALEMENT ET PROCÉDÉ DE NETTOYAGE DE LA TRANCHE DE SEMI-CONDUCTEUR

(43) Veröffentlichungstag der Anmeldung: 13.12.2023
(73) Patentinhaber: Siltronic AG, 81677 München (DE)
(72) Erfinder: Möckel, Bertram, 09599 Freiberg (DE); Brunner, Roland, 84367 Reut (DE); Franke, Jonny, 09575 Eppendorf (DE); Lamprecht, Ludwig, 83376 Truchtlaching (DE); Rothenaicher, Simon, 84567 Erlbach (DE)
(74) Vertreter: Staudacher, Wolfgang

(56) Entgegenhaltungen:
- CN-A- 110 203 683
- CN-A- 112 676 705
- CN-U- 213 845 245
- JP-A- 2001 179 579
- KR-A- 20050 065 749
- US-A1- 2018 282 893

## Beschreibung

Gegenstand der Erfindung ist ein Greifer zum Transportieren einer stehend angeordneten Halbleiterscheibe, umfassend
einen flachen Körper mit einem Kopfabschnitt und einem Fußabschnitt, die eine ebene Vorderseite bilden;
Arme, die sich vom Kopfabschnitt bis zu voneinander beabstandeten Enden im Fußabschnitt erstrecken;
an Endabschnitten der Arme eine aus der Ebene der Vorderseite zurückgesetzt angeordnete Stützfläche; und
auf den Endabschnitten angeordnete Haltestifte zum Erzeugen einer klemmenden Verbindung zwischen der Halbleiterscheibe und dem Körper.

### Stand der Technik / Probleme

Greifer dieser Art werden insbesondere in Reinigungsstraßen eingesetzt, in denen Halbleiterscheiben nach einer chemisch-mechanischen Politur (CMP) einzeln in ein Reinigungsmodul transportiert und gereinigt werden. Eine Reinigungsstraße (running beam device) dieser Art ist beispielsweise in US2020 0 203 152 A1 beschrieben. Ein solcher Greifer wird auch als Klinge (blade) bezeichnet.

In CN213 845 245 U ist ein derartiger Greifer gezeigt. Nachteilig daran ist, dass er eine Halbleiterscheibe nach der Reinigung nicht ausreichend davor schützt, dass flüssiges Reinigungsmittel vom Greifer auf die Halbleiterscheibe gelangt und im Reinigungsmittel enthaltene Partikel auf diese Weise die gereinigte Halbleiterscheibe erneut verunreinigen können und/oder nachträglich auf die Halbleiterscheibe gelangendes Reinigungsmittel die Rauheit der Oberfläche der Halbleiterscheibe verändert.

Aufgabe der Erfindung ist es, diese Gefahr einer Rekontamination der gereinigten Halbleiterscheibe zu verringern.

Die Aufgabe der Erfindung wird gelöst durch einen Greifer zum Transportieren einer stehend angeordneten Halbleiterscheibe, umfassend
einen flachen Körper mit einem Kopfabschnitt und einem Fußabschnitt, die eine ebene Vorderseite bilden;
Arme, die sich vom Kopfabschnitt bis zu voneinander beabstandeten Enden im Fußabschnitt erstrecken;
an Endabschnitten der Arme eine aus der Ebene der Vorderseite zurückgesetzt angeordnete Stützfläche; und
auf den Endabschnitten angeordnete Haltestifte zum Erzeugen einer klemmenden Verbindung zwischen der Halbleiterscheibe und dem Körper, gekennzeichnet durch eine einer Innenseite der Arme folgende Rinne, die in die Arme eingearbeitet ist und an Kanten endet, wobei die Kanten von den Enden der Arme abgespreizt sind.

Die vorgeschlagene Rinne leitet Flüssigkeit größtenteils an der Halbleiterscheibe vorbei zu den Kanten der Rinne, von denen sie abtropfen kann, ohne zuvor zur Oberfläche der Halbleiterscheibe zu gelangen. Vorzugsweise erstreckt sich die Rinne nach vorne, ragt also etwas aus der Ebene der Vorderseite heraus. Vorzugsweise ist die Innenseite der Arme halbkreisartig zusammenlaufend gekrümmt. Eine davon abweichende Form der Arme, beispielsweise Arme mit im Fußabschnitt gleichbleibendem Abstand zueinander, ist auch möglich.

Der Körper des Greifers ist dicker als die zu transportierende Halbleiterscheibe und besteht vorzugsweise aus einem Polymer.

Im Kopfabschnitt sind vorzugsweise Aussparungen vorhanden, die das Gewicht des Greifers und dessen Strömungswiderstand reduzieren.

Die Halbleiterscheibe besteht vorzugsweise aus einkristallinem Silizium und hat einen Durchmesser von vorzugsweise 300 mm oder größer.

Gegenstand der Erfindung ist auch ein Verfahren zum Reinigen einer Halbleiterscheibe in einer Reinigungsstraße, wobei die Halbleiterscheibe stehend angeordnet aus einem Reinigungsmodul der Reinigungsstraße transportiert wird, dadurch gekennzeichnet, dass die Halbleiterscheibe währenddessen von einem Greifer gemäß einem der vorstehenden Patentansprüche transportiert wird. Das Verfahren wird vorzugsweise nach einer CMP angewendet.

Die Erfindung wird nachfolgend mit Verweis auf Zeichnungen weiter beschrieben.

### Kurzbeschreibung der Figuren

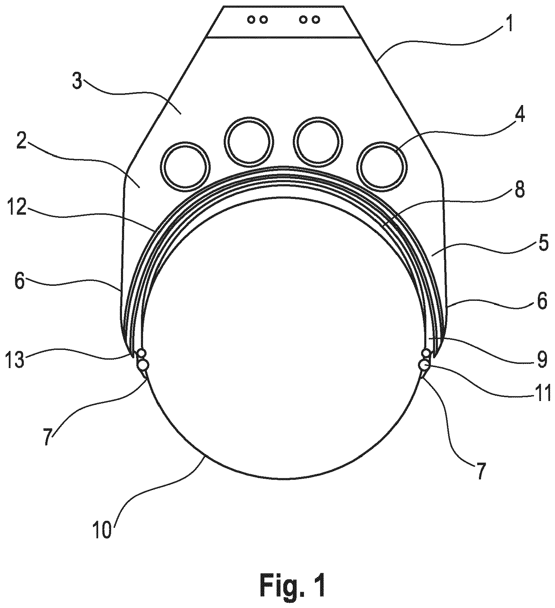

Fig. 1 zeigt die Vorderseite einer erfindungsgemäßen Ausführungsform des Greifers und einer von diesem transportierten Halbleiterscheibe.
Fig. 2 zeigt einen vergrößerten Ausschnitt von Fig. 1.
**Fig. 3** zeigt eine Teilansicht von Fig. 1, die um fast 90° um eine vertikale Achse gegen den Uhrzeigersinn gedreht ist.

### Liste der verwendeten Bezugszeichen

- **1**: Greifer
- **2**: Körper
- **3**: Kopfabschnitt
- **4**: Aussparungen
- **5**: Fußabschnitt
- **6**: Arme
- **7**: Enden
- **8**: Innenseite
- **9**: Stützfläche
- **10**: Halbleiterscheibe
- **11**: Haltestifte
- **12**: Rinne
- **13**: Kante

### Detaillierte Beschreibung eines erfindungsgemäßen Ausführungsbeispiels

Der Greifer 1 umfasst einen flachen Körper 2 mit einem Kopfabschnitt 3 mit Aussparungen 4 und einen Fußabschnitt 5, der von Armen 6 gebildet wird, die sich vom Kopfabschnitt 3 zu Enden 7 im Fußabschnitt 5 erstrecken. Die Arme 6 dieser Ausführungsform sind entlang einer Innenseite 8 gekrümmt und vereinigen sich im Kopfabschnitt 3. Der Kopfabschnitt 3 und der Fußabschnitt 5 bilden eine ebene Vorderseite des Körpers.

An den Endabschnitten der Arme 6 ist eine Stützfläche 9 vorhanden, die aus der Ebene der Vorderseite zurückgesetzt angeordnet ist. Darüber hinaus sind auf den Endabschnitten Haltestifte 11 angeordnet, mit deren Hilfe eine klemmende Verbindung zwischen der Halbleiterscheibe 10 und dem Körper 2 erzeugt wird.

Der Greifer 1 weist darüber hinaus eine der Krümmung der Arme 6 folgende Rinne 12 auf, die an Kanten 13 endet. Die Rinne 12 ist in den Körper 2 eingearbeitet und folgt der Krümmung der Innenseite 8 der Arme in einem gewissen Abstand.

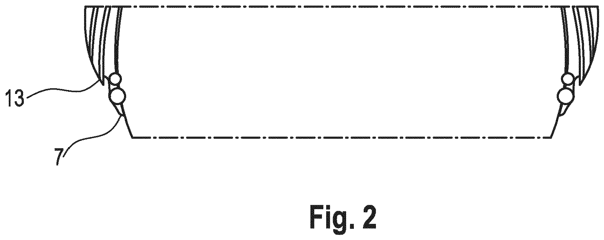

In Fig. 2 ist hervorgehoben, dass die Kanten 13 und die Enden 7 der Arme 6 voneinander abgespreizt sind. Die Enden der Kanten 12 weisen eher voneinander weg nach außen, die Enden 7 der Arme 6 eher aufeinander zu nach innen.

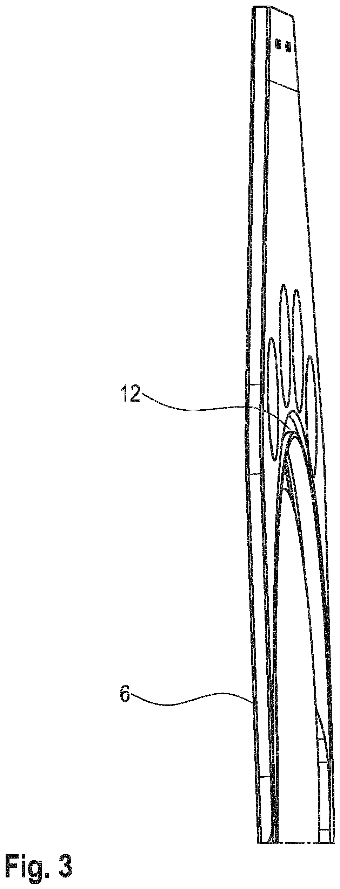

Fig. 3 zeigt eine Perspektive, in der die Rinne 12 gut zu erkennen ist. Die Rinne 12 folgt bis zu den Kanten 13 weitgehend der Krümmung der Innenseite 8 der Arme 6. Gemäß der gezeigten Ausführungsform ragt die Rinne 12 etwas aus der Ebene der Vorderseite heraus.

Der Weg für Flüssigkeit nach dem Transport des Greifers 1 aus einem Reinigungsmodul führt vom Kopfabschnitt 3 des Körpers 2 überwiegend entlang der Rinne 12 zu den Kanten 13. Von dort tropft die Flüssigkeit beispielsweise ins Reinigungsmodul zurück. Rückstände von Flüssigkeit auf der Halbleiterscheibe 10 sind deutlich reduziert.

Der Schutzbereich des Patents wird durch die Patentansprüche bestimmt.

## Patentansprüche

1. Greifer (1) zum Transportieren einer stehend angeordneten Halbleiterscheibe (10), umfassend
einen flachen Körper (2) mit einem Kopfabschnitt (3) und einem Fußabschnitt (5), die eine ebene Vorderseite bilden;
Arme (6), die sich vom Kopfabschnitt bis zu voneinander beabstandeten Enden im Fußabschnitt erstrecken;
an Endabschnitten der Arme eine aus der Ebene der Vorderseite zurückgesetzt angeordnete Stützfläche (9); und
auf den Endabschnitten angeordnete Haltestifte (11) zum Erzeugen einer klemmenden Verbindung zwischen der Halbleiterscheibe und dem Körper, **gekennzeichnet durch** eine einer Innenseite (8) der Arme folgende Rinne (12), die in die Arme eingearbeitet ist und an Kanten (13) endet, wobei die Kanten von den Enden der Arme abgespreizt sind

2. Greifer nach Anspruch 1, **gekennzeichnet durch** Aussparungen im Kopfabschnitt.

3. Greifer nach Anspruch 1 oder Anspruch 2, **gekennzeichnet durch** das Herausragen der Rinne aus der Ebene der Vorderseite.

4. Greifer nach einem der Ansprüche 1 bis 3, **dadurch gekennzeichnet, dass** die Innenseite der Arme gekrümmt ist.

5. Verfahren zum Reinigen einer Halbleiterscheibe (10) in einer Reinigungsstraße, wobei
die Halbleiterscheibe stehend angeordnet aus einem Reinigungsmodul der Reinigungsstraße transportiert wird, **dadurch gekennzeichnet, dass** die Halbleiterscheibe währenddessen von einem Greifer (1) gemäß einem der vorstehenden Patentansprüche transportiert wird.

## Claims

1. Gripper (1) for transporting an upright semiconductor wafer (10), comprising
a flat body (2) having a head portion (3) and a foot portion (5), which form a planar front side;
arms (6), which extend from the head portion to spaced-apart ends in the foot portion;
at end portions of the arms, a supporting surface (9), which is arranged so as to be set back from the plane of the front side; and
holding pins (11), which are arranged on the end portions and are intended for establishing a clamping connection between the semiconductor wafer and the body, **characterized by** a channel (12) which follows an inner side (8) of the arms, is made in the arms and terminates at edges (13), wherein the edges are separated from the ends of the arms.

2. Gripper according to Claim 1, **characterized by** apertures in the head portion.

3. Gripper according to Claim 1 or Claim 2, **characterized by** the channel projecting out of the plane of the front side.

4. Gripper according to one of Claims 1 to 3, **characterized in that** the inner side of the arms is curved.

5. Method for cleaning a semiconductor wafer (10) in a cleaning line, wherein the semiconductor wafer is transported in an upright state out of a cleaning module of the cleaning line, **characterized in that**, during this time, the semiconductor wafer is transported by a gripper (1) according to one of the preceding patent claims.

## Revendications

1. Préhenseur (1) destiné à transporter une plaquette de semi-conducteur (10) disposée verticalement, ledit préhenseur comprenant
un corps plat (2) pourvu d'une portion de tête (3) et d'une portion de pied (5), lesquelles forment un côté avant plat ;
des bras (6) qui s'étendent depuis la portion de tête jusqu'aux extrémités espacées l'une de l'autre dans la portion de pied ;
une surface d'appui (9), en retrait du plan du côté avant, au niveau des portions d'extrémités des bras ; et
des broches de retenue (11), disposées sur les portions d'extrémité et destinées à réaliser une liaison par serrage entre la plaquette de semi-conducteur et le corps, **caractérisé par**
une rainure (12) qui suit un côté intérieur (8) des bras, qui est ménagée dans les bras et qui se termine au niveau des bords (13), les bords étant écartés des extrémités des bras.

2. Préhenseur selon la revendication 1, **caractérisé en ce que** des évidements sont ménagés dans la portion de tête.

3. Préhenseur selon la revendication 1 ou la revendication 2, **caractérisé en ce que** la rainure fait saillie du plan du côté avant.

4. Préhenseur selon l'une des revendications 1 à 3, **caractérisé en ce que** le côté intérieur des bras est incurvé.

5. Procédé de nettoyage d'une plaquette de semi-conducteur (10) dans une ligne de nettoyage,
la plaquette de semi-conducteur étant transportée en position verticale depuis un module de nettoyage de la ligne de nettoyage, **caractérisé en ce que** la plaquette de semi-conducteur est transportée pendant ce temps par un préhenseur (1) selon l'une des revendications précédentes.
